# EUROPEAN PATENT APPLICATION

(11) **EP 2 881 934 A1**
(43) Date of publication of application: **10.06.2015**
(21) Application number: 12866403.4
(22) Date of filing: 14.12.2012
(51) Int. Cl.: G09G 3/36, G11C 19/28

(54) **SHIFT REGISTER UNIT, SHIFT REGISTER AND DISPLAY DEVICE**

(30) Priority: 30.07.2012 CN 201210266145
(71) Applicant: BOE Technology Group Co., Ltd., Beijing 100015 (CN); Chengdu BOE Optoelectronics Technology Co., Ltd., Hi-tech Development Zone Chengdu Sichuan 611731 (CN)
(72) Inventor: QING, Haigang, Beijing 100176 (CN); QI, Xiaojing, Beijing 100176 (CN)
(74) Representative: Brötz, Helmut
(86) International application number: PCT/CN2012/086704
(87) International publication number: WO 2014/019315

(57) **Abstract**

A shift register unit, shift register and display apparatus, for addressing the issue that the leakage current of the depletion TFT affects the shift register. The shift register unit includes: a first output control module (51); a second output control module (52); a staged output module (53), being connected to a pull-up node (PU), a pull-down node (PD), a carry signal output terminal (CA(n)) and a driving signal output terminal (OUT(n)) respectively, for maintaining the driving signal at a high level during an evaluation phase and maintaining the same at a low level during a resetting phase and a pre-charging phase as well as during a non-operation phase by outputting the carrying signal and the driving signal in a staged mode; and a pull-up node level maintaining capacitor (C1), with one terminal connected to the first low level output terminal and the other terminal connected to the source of a first Thin Film Transistor (T1) comprised in the first output control module (51), for maintaining the pull-up node (PU) at a high level by the first output control module (51) during the evaluation phase, so that to maintain the driving signal at a high level.

## Description

### TECHNICAL FIELD

The present invention relates to a field of an organic light-emitting display, particularly to a shift register unit, shift register and display apparatus.

### BACKGROUND

There is a trend that a display has high resolution and narrow bezel with the development of a flat display. To implement a display with high resolution and narrow bezel, it is the most important solution that a gate driving circuit is integrated on a panel. For the amorphous silicon (a-si) and polysilicon (p-si) technique, various existing mature shift register circuits can achieve the goal of integrating the gate driving circuit on the panel. The technique of utilizing an oxide Thin Film Transistor (TFT) as a potential semiconductor technique, has advantages of simpler technical process and lower cost compared to p-si technical process, and higher mobility over a-si technical process, and thus gains more and more concerns. In the future, it is likely to be adopted as a main-stream backboard driving technique by the Organic Light-Emitting Diode (OLED), and the flexible display. The oxide TFT is of a depletion transistor, and the a-si TFF and p-si TFT mentioned above are of enhancement transistors.

Fig.1 illustrates a circuit diagram of a conventional elementary shift register unit. As shown in Fig.1, the elementary shift register unit includes a pull-up TFT T1, a pull-down TFT T2, a bootstrap capacitor C1, a pull-up control TFT T3, a pull-down control TFT T4, a storage capacitor C2, a first clock signal input terminal CK, a second clock signal input terminal CKB, an input terminal Input, a Reset terminal Reset and an output terminal Output;
a pull-up node (node PU) is connected to a gate of T1, and a pull-down node (node PD) is connected to a gate of T2;
a start signal STV is input from the input terminal Input, and VGL is at a low level.

Fig.2 is a timing sequence diagram of signals when the elementary shift register unit is in operation, and VGH is at a high level.

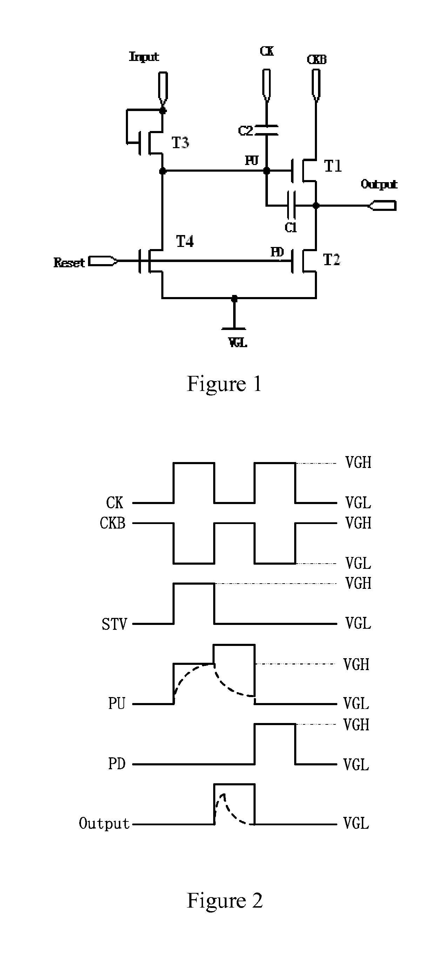

When utilizing an enhancement TFT technique to manufacture the circuit of the elementary shift register unit, the circuit can operate normally, as shown in the portion with solid line in Fig.2; however, when utilizing the oxide transistor (depletion transistor) to manufacture the circuit, the circuit would fail since the pull-down transistor can not be switched off, as shown in the portion with dotted line in Fig.2.

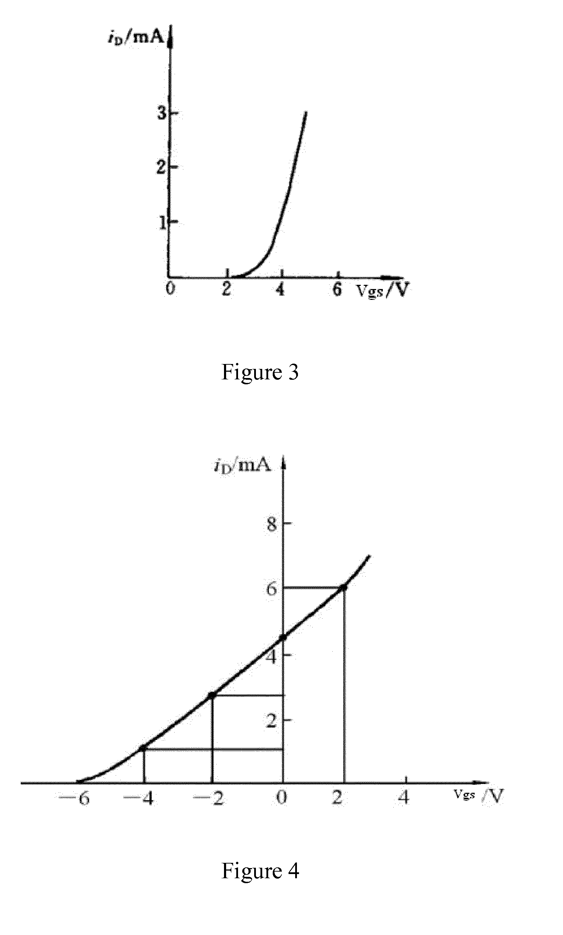

The difference between an enhancement transistor and a depletion transistor is shown in Figs 3 and 4. Fig. 3 illustrates a characteristic curve of an enhancement transistor, wherein the vertical axis of Fig. 3 shows a drain current i_{D} of the enhancement transistor, and the horizontal axis of Fig.3 shows a gate-source voltage V_{gs} of the enhancement transistor. It can be seen from Fig. 3 that when V_{gs} is equal to zero, i_{D} is equal to zero, which indicates that the enhancement transistor is completely switched off when Vgs is equal to zero. Fig. 4 shows a characteristic curve of a depletion transistor, as such, wherein the vertical axis of Fig. 4 shows a drain current i_{D} of the depletion transistor, and the horizontal axis of Fig.4 shows a gate-source voltage V_{gs} of the depletion transistor. However, as indicated in Fig. 4, when V_{gs} is equal to zero, i_{D} is far greater than zero, and only when the gate-source voltage V_{gs} is equal to -6V, i_{D} is equal to zero; and thus, the depletion transistor is still in switch-on state when the gate-source voltage Vgs is equal to zero, and can not be switched off. Therefore, when the oxide transistor is utilized to manufacture the existing circuit that operates normally with a-si technique or p-si technique, there is a large leakage current since the oxide transistor can not be switched off, and thus the conventional elementary shift register unit circuit as shown in Fig. 1 can not be applicable any more.

### SUMMARY

The embodiments of the present invention provide a shift register unit, shift register and display apparatus, for addressing the issue that the leakage current of the depletion TFT affects the shift register.

A shift register unit as provided in the embodiment of the present invention includes:
a first output control module, being connected to a pull-up node, for pulling up the pull-up node to a high level during an evaluation phase, and pulling down the pull-up node to a first low level during a resetting phase;
a second output control module, being connected to a pull-down node, for pulling up the pull-down node to a high level during the resetting phase and a non-operation phase;
a staged output module, being connected to the pull-up node, the pull-down node, a carry signal output terminal and a driving signal output terminal respectively, for maintaining the driving signal at a high level during the evaluation phase and maintaining the same at a low level during the resetting phase and the pre-charging phase as well as during the non-operation phase by outputting the carrying signal and the driving signal in a staged mode; and
a pull-up node level maintaining capacitor, with one terminal connected to the first low level output terminal and the other terminal connected to the source of a first Thin Film Transistor (TFT), for maintaining the pull-up node at a high level by the first output control module during the evaluation phase.

In one embodiment, the first output control module includes a first TFT, a second TFT, a third TFT and a fourth TFT, wherein the first TFT has a gate and a drain connected to an input terminal, and a source connected to a drain of the second TFT; the second TFT has a gate connected to the input terminal Input, a source connected to the pull-up node; the third TFT T3 has a gate connect to a reset terminal, a source connected to a drain of the fourth TFT and the source of the first TFT respectively, and a drain connected to the pull-up node; and the fourth TFT has a gate connected to the reset terminal RST, and a source connected to a first low level output terminal.

In one embodiment, the staged output module includes:
a carry output unit, for outputting a first low level at a carry signal output terminal under the controls of the first output control module and the second output control module during the pre-charging phase, the resetting phase and the non-operation phase, and for outputting a high level at the carry signal output terminal under the controls of the first output control module and the second output control module during the evaluation phase;
the driving output unit, for outputting a high level at the driving signal output terminal under the controls of the first output control module and the second output control module during the evaluation phase, and for outputting a second low level at the driving signal output terminal under the controls of the first output control module and the second output control module during the pre-charging phase, the resetting phase and the non-operation phase.

In an embodiment, the carry output unit includes a first carry output TFT and a second carry output TFT; the driving output unit includes a first driving TFT, a second driving TFT and a bootstrap capacitor;
wherein the first carry output control TFT has a gate connected to the first output control module, a source connected to the carry signal output terminal, and a drain connected to a clock signal input terminal;
the second carry output TFT has a gate connected to the second output control module, a source connected to the first low level output terminal, and a drain connected to the carry signal output terminal;
the bootstrap capacitor is connected in parallel to the gate and the source of the first driving TFT;
the first driving TFT has a gate connected to the first output control module, a source connected to the driving signal output terminal, and a drain connected to the clock signal input terminal;
the second driving TFT has a gate connected to the second output control module, a source connected to the second low level output terminal, and a drain connected to the driving signal output terminal;

In an embodiment, the second low level is greater than the first low level.

In an embodiment, the second output control module includes a pull-down control TFT and a pull-down capacitor, wherein:
pull-down control TFT has a gate connected to the pull-up node, a source connected to the first low level output terminal, a drain connected to the pull-down node and a first terminal of the pull-up capacitor; and
the pull-down capacitor has a second terminal connected to the clock signal input terminal.

In an embodiment, the first carry output TFT, the second carry output TFT, the first driving TFT and the second driving TFT are of depletion TFTs.

An embodiment of the present invention further provides a shift register comprising a plurality of the shift register units as mentioned above at stages, wherein
except the shift register unit at the first stage, the input terminal of the shift register unit at each stage is connected to the carry signal output terminal of the shift register unit at the previous stage;
except the shift register unit at the last stage, the reset terminal of the shift register unit at each stage is connected to the carry signal output terminal of the shift register unit at the next stage;
the input terminal of the shift register unit at the first stage receives the start signal; and
the reset terminal of the shift register unit at the last stage receives the driving signal output from the shift register unit at the last stage.

An embodiment of the present invention further provides a display apparatus comprising the shift register mentioned above.

Compared to the prior art, in the shift register unit, shifter register and display apparatus as provided in the embodiments of the present invention, the pull-up node level maintaining capacitor is applied to maintain the pull-up node at a high level during the evaluation phase to stabilize the existing potential at the source of the TFT, which is included in the staged output module, being connected to the pull-up node for pulling up the driving, so that the voltage difference between the gate and the source of the TFT for pulling up the driving is below zero and below the threshold voltage when the potential of the gate of the TFT is pulled down, and thus for the depletion transistor, the TFT is in a switch-off state, and the leakage current is greatly decreased, which prevents the potential of the pull-up node from being pulled down, and solves the problem of leakage current in the depletion shift register circuit and ensures the normal operation of the shift register unit; further, the staged output module is applied to maintain the driving signal at a high level during the evaluation phase and maintain the same at a low level during the resetting phase and the pre-charging phase as well as during the non-operation phase by outputting the carry signal and the driving signal in a staged mode, which addresses the problem that the influence of the leakage current of the depletion TFT over the driving signal of the shift register unit.

### BRIEF DESCRIPTION OF THE DRAWINGS

In following description, the features and advantages of the invention will be more apparent in connection with the appended drawings. In the whole drawings, the same element is denoted with the same reference number, wherein,
Fig. 1 illustrates a circuit diagram of a conventional elementary shift register unit;
Fig.2 illustrates a timing-sequence diagram of signals when the elementary shift register unit is in operation;
Fig. 3 illustrates a characteristic curve of an enhancement transistor;
Fig. 4 illustrates a characteristic curve of an depletion transistor;

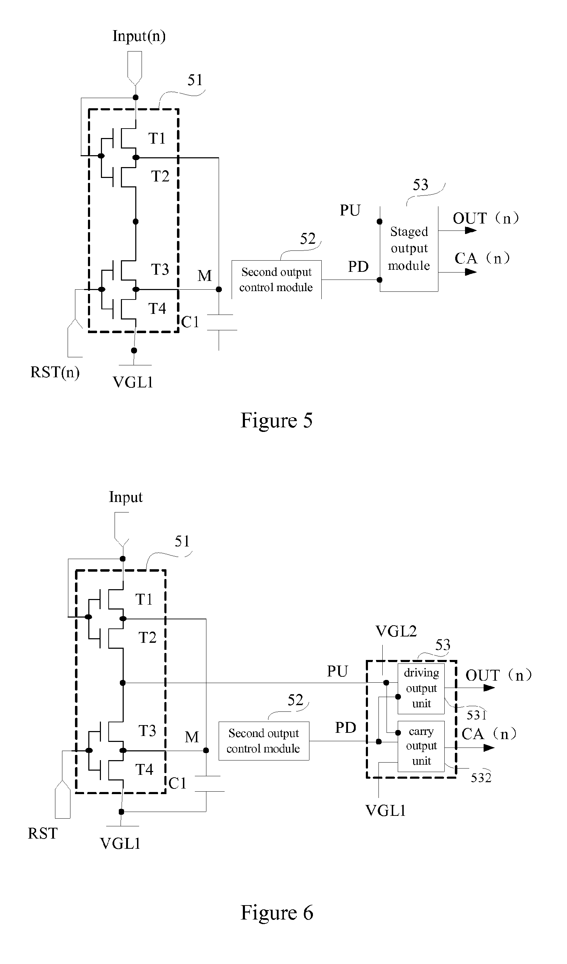

Fig. 5 illustrates a circuit diagram of a shift register unit according to a first embodiment of the present invention;
Fig. 6 illustrates a circuit diagram of a shift register unit according to a second embodiment of the present invention;

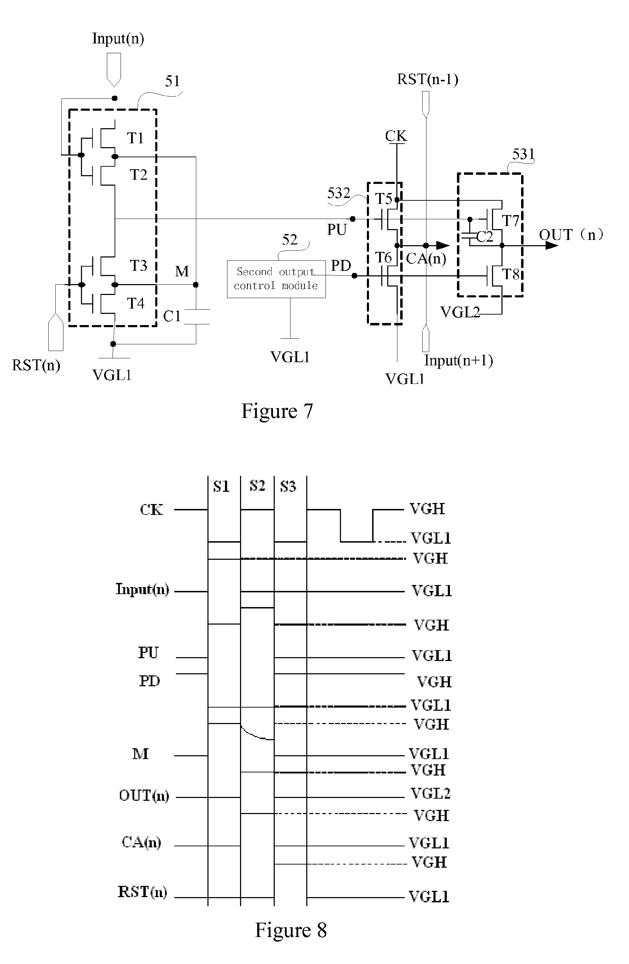

Fig. 7 illustrates a circuit diagram of a shift register unit according to a third embodiment of the present invention;
Fig. 8 illustrates a timing-sequence diagram of signals when the shift register unit according to the third embodiment of the present invention is in operation;

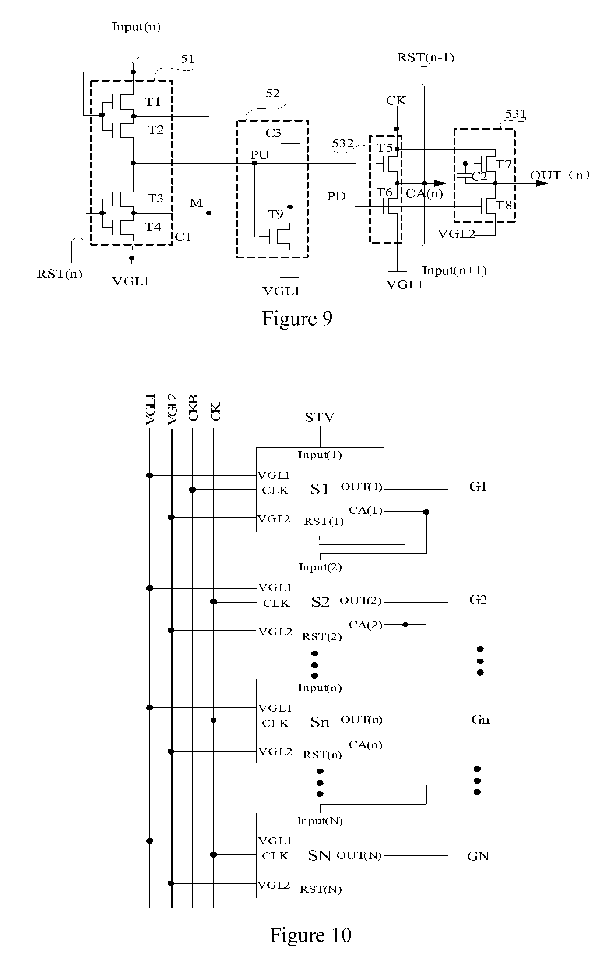

Fig. 9 illustrates a circuit diagram of a shift register unit according to a fourth embodiment of the present invention; and
Fig. 10 illustrates a circuit diagram of a shift register according to an embodiment of the present invention.

### DETAILED DESCRIPTION OF THE PREFERRED EMBODIMENTS

To make the object, technical solution and advantageous of the present invention more clear, hereinafter, a detailed description will be further made to the embodiments of the present invention in connection with the appended drawings.

Embodiments of the present invention provide a shift register unit, shift register and display apparatus, to address the issue of the influence of a leakage current to a depletion transistor over the shift register.

As shown in Fig. 5, the shift register unit according to the first embodiment of the present invention includes:
a first output control module 51, being connected to a pull-up node PU, for pulling up the pull-up node to a high level during an evaluation phase, and pulling down the pull-up node to a first low level during a resetting phase;
a second output control module 52, being connected to a pull-down node PD, for pulling up the pull-down node to a high level during the resetting phase and a non-operation phase;
wherein the first output control module 51 includes a first TFT T1, a second TFT T2, a third TFT T3 and a fourth TFT T4;
the first TFT T1 has a gate and a drain connected to an input terminal Input(n), and a source connected to a drain of the second TFT T2;
the second TFT T2 has a gate connected to the input terminal Input(n), a source connected to the pull-up node PU;
the third TFT T3 has a gate connect to a reset terminal RST(n), a source connected to a drain of the fourth TFT T4 and the source of the first TFT T1 respectively, and a drain connected to the pull-up node PU; and
the fourth TFT T4 has a gate connected to the reset terminal RST(n), and a source connected to a first low level output terminal.

The shift register unit according to the first embodiment of the present invention further comprises:
a staged output module 53, being connected to the pull-up node (node PU), the pull-down node (node PD), a carry signal output terminal CA(n) and a driving signal output terminal OUT(n) respectively, for maintaining the driving signal at a high level during the evaluation phase and maintaining the same at a low level during the resetting phase and the pre-charging phase as well as during the non-operation phase by outputting the carrying signal and the driving signal in a staged mode;
a pull-up node level maintaining capacitor C1, with one terminal connected to the first low level output terminal and the other terminal connected to the source of the first TFT T1, for maintaining the pull-up node (node PU) at a high level by the first output control module 51 during the evaluation phase;
wherein the carry signal output terminal of the shift register unit according to the first embodiment of the present invention is connected to an input terminal Input(n+1) of a shift register unit at next stage, and to a reset terminal RST(n-1) of a shift register unit at previous stage (not shown in Fig.5);
node M is connected to the source of the first TFT T1, and the first low level output terminal outputs a first low level VGL1.

In the shift register unit according to first embodiment of the present invention, the pull-up node level maintaining capacitor C1 is mainly used to maintain of the pull-up node (node PU) at a high level in the evaluation phase. In particular, the existing potential of the source of a TFT (not shown in Fig.5) connected to node PU is stabilized by the capacitor C1 so that the voltage difference between the gate and the source of the TFT is below zero and below the threshold voltage when the potential of the gate of the TFT is pulled down, and thus for the depletion transistor, the TFT is in a switch-off state, and the leakage current is greatly decreased, which prevents the potential of the node PU from being pulled down, and solves the problem of leakage current in the depletion shift register circuit and ensures the normal operation of the shift register unit.

Further, in the shift register unit according to the first embodiment of the present invention, the staged output module 53 is applied to maintain the driving signal at a high level during the evaluation phase and maintain the same at a low level during the resetting phase and the pre-charging phase as well as during the non-operation phase by outputting the carry signal and the driving signal in a staged mode, which addresses the problem of the influence of the leakage current to the depletion TFT over the driving signal of the shift register unit.

Fig. 6 shows a circuit diagram of a shift register unit according to a second embodiment of the present invention. The shift register unit according to the second embodiment of the present invention is based on the shift register unit according to the first embodiment of the present invention. In the second embodiment, the staged output module 53 includes a driving output unit 531 and a carry output unit 532, wherein,
the carry signal output unit 532 is driven by the first low level output terminal;
the driving output unit 531 is driven by the second low level output terminal;
the carry output unit 532 is used for outputting a first low level VGL1 at the carry signal output terminal CA(n) under the control of the first output control module 51 during the pre-charging phase, the resetting phase and the non-operation phase, and for outputting a high level at the carry signal output terminal under the control of the second output control module during the evaluation phase;
the driving output unit 531 is used for outputting a high level at the driving signal output terminal OUT(n) under the control of the second output control module 52 and the first output control module 51 during the evaluation phase, and for outputting a second low level VGL2 at the driving signal output terminal OUT(n) under the control of the first output control module 51 and the second output control module 52 during the resetting phase;
wherein the first low level output terminal outputs the first low level VGL1, and the second low level output terminal outputs the second low level VGL2; and
the first low level VGL1 is different from the second low level VGL2, which prevents the leakage current of the depletion TFT from affecting the driving signal of the shift register unit.

Fig. 7 shows a circuit diagram of a shift register unit according to a third embodiment of the present invention. The shift register unit according to the third embodiment of the present invention is based on the shift register unit according to the second embodiment of the present invention. In the third embodiment, the carry output unit 532 includes a first carry output TFT T5 and a second carry output TFT T6;
the driving output unit 531 includes a first driving TFT T7, a second driving TFT T8 and a bootstrap capacitor C2;
wherein the first carry output TFT T5 has a gate connected to the first output control module 51, a source connected to the carry signal output terminal CA(n), and a drain connected to a clock signal input terminal;
the bootstrap capacitor is connected in parallel to the gate and the source of the first driving TFT T7;
the first driving TFT T7 has a gate connected to the first output control module 51, a source connected to the driving signal output terminal OUT (n), and a drain connected to the clock signal input terminal;
the second carry output TFT T6 has a gate connected to the second output control module 52, a source connected to the first low level output terminal, and a drain connected to the carry signal output terminal CA(n);
the second driving TFT T8 has a gate connected to the second output control module 52, a source connected to the second low level output terminal, and a drain connected to the driving signal output terminal OUT (n);
the first output control module 51 is further connected to the first low level output terminal and the input terminal INPUT(n) respectively; and
the second output control module 52 is further connected to the first low level output terminal.

Furthermore, T5, T6, T7 and T8 are of n type TFTs (Thin Film Transistor).

Furthermore, the first carry output TFT T5, the second carry output TFT T6, the first driving TFT T7 and the second driving TFT T8 are of depletion TFTs.

Wherein, the clock signal input terminal inputs a clock signal CK, the first low level output terminal outputs the first low level VGL1, the second low level output terminal outputs the second low level VGL2, wherein VGL1<VGL2.

In the shift register unit according to the third embodiment of the present invention, the node PU is connected to the gate of the first carry output control TFT T5, and the node PD is connected to the gate of the second carry output control TFT T6. The potentials of the node PU and node PD are controlled by the first output control module 51 and the second output control module 52 respectively.

In the shift register unit according to the third embodiment of the present invention, two different pull-down potentials VGL1 and VGL2 are used, wherein the pull-down potential VGL2 is used to output the driving signal, and the pull-down potential VGL1 is used to output the feedback and carry signal, wherein the VGL2>VGL1. At the same time, in both the input portion and the reset portion of the shift register unit at the present stage, the structure where two TFTs are connected in series is used, the middle point of the structure is connected together and connected to the capacitor C1 at the node M. Further, in the shift register unit according to the third embodiment of the present invention, the clock signal CK as needed has a high level VGH and a low level VGL1; the signal output from the second output control module 52 is applied to the node PD, and has a high level VGH or a low level VGL1; from the fact that the shift register unit at the present stage is connected to the reset terminal RST(n-1) of the shift register unit at the previous stage and the input terminal Input(n+1) of the shift register unit at the next stage, it can be known that the signals received by the input terminal Input(n) and the reset terminal RST(n) of the shift register unit at the present stage have a high level and a low level being VGH and VGL1 respectively.

As shown in Fig.8, the operation process of the shift register unit according to the third embodiment of the present invention can be divided into three phases:
the first phase is the pre-charging phase S1, wherein the clock signal input terminal and the reset terminal RST(n) output the first low level VGL1, and the input terminal Input(n) output the high level VGH, and thus T1 and T2 are turned on, the bootstrap capacitor C2 is charged via the node PU, and the capacitor C1 is also charged via the node M; since the voltage at the source of T4 is VGL1, and at the same time the potential at the RST(n) is also VGL1, Vgs (gate-source voltage) of T4 is equal to zero, and T4 is in a certain switch-on state(from the corresponding characteristic curve, it can be seen that T4 is in a linear area and has a certain resistance). As the capacitor C1 is charged by the input terminal Input(n), the potential at the node M increases rapidly, and the potential at the source of T3 corresponds to the potential at the node M, and the potential at the gate of T3 is equal to VGL1; as a result, the Vgs of T3 is below zero, when the potential at the node M rises to a certain value, T3 is completely switched off. Since T3 is switched off, the potential at the node PU can reach VGH soon; the potential at the node PD is equal to VGL1, the Vgs of T6 is equal to zero, T6 is turned on; since VGL2>VGL1, the Vgs of T8 is below zero, and thus T8 is switched off. As the potential at the node PU increases, T5 and T7 are turned on, OUT(n) outputs a low level VGL1, and CA(n) outputs the low level VGL1;

The second phase is the evaluation phase S2, wherein CK jumps to a high level, the potential at the input terminal Input(n) jumps to a first low level VGL1, and RST(n) still inputs the first low level VGL1, the Vgs of T1 and that of T4 are equal to zero, and thus T1 and T4 are in a certain switch-on state(both are in a linear area and have a certain resistance); both the potential at the gate of T2 and that at the gate of T3 are VGL1, and the potential at the source of T2 and that at the source of T3 correspond to the potential at the node M; the node M is connected to the capacitor C1, although the capacitor C1 is discharged via T1 and T4 slowly, the potential at the node M can not jump to VGL1 rapidly, but decreases slowly; only the capacitance value of the capacitor C1 reaches a pre-determined value, the potential difference across the capacitor C1 during the period of a half pulse width can be maintained above VGL1 by a certain value, and the gate-source voltage Vgs of T2 and that of T3 are below zero, which ensures T2 and T3 to be in a switch-off state so that the potential at the node PU continues to be maintained at a high level, and T5 and T7 continue to be turned on; the potential at the node PD continues to be maintained at the low level VGL1, T8 continues to be turned off, and T6 is kept in a certain switch-on state; at the same time, CK is at a high level, the potential at the node PU is further increased via the capacitor C2, and T5 and T7 are further turned on; therefore, the driving signal output terminal OUT(n) outputs the high level VGH, and at the same time the carry signal output terminal CA(n) outputs the high level VGH;
the third phase is the resetting phase S3, wherein CK jumps to the first low level VGL1, RST(n) and the node PD output the high level VGH, and thus T6 and T8 are turned on fully, T3 and T4 are turned on fully; the potentials at the node PU and at node M are pulled down to VGL1, the driving signal output terminal OUT(n) outputs VGL2, and the carry signal output terminal CA(n) outputs VGL1 since T6 and T8 are turned on;
until now, the operation of the shift register unit ends, and after the potential at the node PU is pulled down to VGL1, the Vgs of T7 is below zero since the driving output terminal OUT(n) outputs VGL2, and T7 is switched off. Therefore, the output of the driving signal output terminal OUT(n) can not be affected when CK becomes a high level again; T5 may be in a slight switch-on state, but since T6 is turned on, the carry signal output terminal CA(n) outputs VGL1.

Fig. 9 shows a circuit diagram of a shift register unit according to a fourth embodiment of the present invention. The shift register unit according to the fourth embodiment of the present invention is based on the shift register unit according to the third embodiment of the present invention.

As shown in Fig. 9, in the fourth embodiment, the second output control module 52 includes a pull-down control TFT T9 and a pull-up capacitor C3, wherein:

The pull-down control TFT T9 has a gate connected to the pull-up node(node PU), a source connected to the first low level output terminal, a drain connected to the pull-down node(node PD) and a first terminal of the pull-up capacitor C3;
the pull-up capacitor C3 has a second terminal connected to the clock signal input terminal.

It should be noted that there are many schemes for the second output control module 52 according to the embodiment of the present invention, and the second output control module 52 as shown in Fig. 9 is only one of the possible embodiments. The differences in the second output control module 52 do not belong to the substantive differences between the present invention and other schemes. The schemes which adopt the technical solution of the present invention all fall into the scope as claimed in the present invention regardless of the second output control module utilizing which embodiment.

An embodiment of the present invention further provides a shift register comprising a plurality of the shift register units as mentioned above at stages, wherein
except the shift register unit at the first stage, the input terminal of the shift register unit at each stage is connected to the carry signal output terminal of the shift register unit at the previous stage;
except the shift register unit at the last stage, the reset terminal of the shift register unit at each stage is connected to the carry signal output terminal of the shift register unit at the next stage;
the input terminal of the shift register unit at the first stage receives the start signal; and
the reset terminal of the shift register unit at the last stage receives the driving signal output from the shift register unit at the last stage.

As shown in Fig. 10, an shift register according to an embodiment of the present invention comprises a plurality of shift register units at N stages, functioning as a line scanner of an active matrix, wherein N generally represents the number of the lines of the active matrix, and N is a positive integer;
S1, S2, ..., Sn,..., SN denotes the shift register unit at the first stage, the shift register unit at the second stage,..., the shift register unit at the nth stage, ..., and the shift register unit at the Nth stage;
a clock signal output from the first clock signal input terminal and a clock signal input to the second clock signal input terminal have opposite phases and a duty cycle of 50%;
wherein, the input terminal IN of the shift register unit at the first stage receives an initial pulse signal STV which is active at a high level;
the reset terminal of the shift register unit at the last stage receives the driving signal output from the shift register unit at the last stage;
except the shift register unit at the first stage, the input terminal of the shift register unit at each stage is connected to the carry signal output terminal of the shift register unit at the previous stage; the shift register unit at each stage has two output terminals: CA(n), as the carry signal output terminal, being connected to the input terminal Input(n+1) of the shift register unit at the next stage and the reset terminal RST(n-1) of the shift register unit at the previous stage respectively; and OUT(n), as the driving signal output terminal, being connected to a line scanning wire Gn of the active matrix, wherein n is a positive integer, and less than or equal to N;
the clock control signals of the two shift register units at adjacent stages have opposite phases, for example, if the clock input terminal of the shift register unit at the first stage is connected to the clock signal CK, the clock signal input terminal of the shift register unit at the second stage adjacent to the first stage is connected to the clock signal CKB, wherein the clock signal CK and the clock signal CKB have opposite phases.

An embodiment of the present invention further provides a display apparatus comprising the shift register as recited in the embodiments mentioned above, and the display apparatus can include a liquid crystal display (LCD) apparatus, such as a LCD panel, LCD TV, mobile phone, LCD display, and the like. Besides the LCD display apparatus, the display apparatus can also comprise an organic light-emitting display and other types of display apparatus, such as an electronic reader and etc. The shift register can be used as a scanning circuit or a gate driving circuit of the display apparatus, for providing a progressive scanning function to supply scanning signals to the display area.

The above description is only for illustrating the present invention and not for making any limitation on the present invention. It should be appreciated for those skilled in the art that many modifications, variations or equivalences can be made in the embodiments of the present invention without departing from the spirit and the scope of the invention, and that they all fall into the protection scope as claimed in the present invention.

## Claims

1. A shift register unit, including:
a first output control module, being connected to a pull-up node, for pulling up the pull-up node to a high level during an evaluation phase, and pulling down the pull-up node to a first low level during a resetting phase;
a second output control module, being connected to a pull-down node, for pulling up the pull-down node to a high level during the resetting phase and a non-operation phase;
a staged output module, being connected to the pull-up node, the pull-down node, a carry signal output terminal and a driving signal output terminal respectively, for maintaining the driving signal at a high level during the evaluation phase and maintaining the same at a low level during the resetting phase and the pre-charging phase as well as during the non-operation phase by outputting the carrying signal and the driving signal in a staged mode;
a pull-up node level maintaining capacitor, with one terminal connected to the first low level output terminal and the other terminal connected to the source of a first Thin Film Transistor (TFT), for maintaining the pull-up node at a high level by the first output control module during the evaluation phase.

2. The shift register unit according to claim 1, wherein the first output control module includes a first TFT, a second TFT, a third TFT and a fourth TFT, wherein the first TFT has a gate and a drain connected to an input terminal, and a source connected to a drain of the second TFT; the second TFT has a gate connected to the input terminal, a source connected to the pull-up node; the third TFT T3 has a gate connect to a reset terminal, a source connected to a drain of the fourth TFT and the source of the first TFT respectively, and a drain connected to the pull-up node; and the fourth TFT has a gate connected to the reset terminal, and a source connected to a first low level output terminal.

3. The shift register unit according to claim 2, wherein the staged output module includes:
a carry output unit, for outputting a first low level at a carry signal output terminal under the controls of the first output control module and the second output control module during the pre-charging phase, the resetting phase and the non-operation phase, and for outputting a high level at the carry signal output terminal under the controls of the first output control module and the second output control module during the evaluation phase;
the driving output unit, for outputting a high level at the driving signal output terminal under the controls of the first output control module and the second output control module during the evaluation phase, and for outputting a second low level at the driving signal output terminal under the controls of the first output control module and the second output control module during the pre-charging phase, the resetting phase and the non-operation phase.

4. The shift register unit according to claim 3, wherein
the carry output unit includes a first carry output TFT and a second carry output TFT; the driving output unit includes a first driving TFT, a second driving TFT and a bootstrap capacitor;
the first carry output TFT has a gate connected to the first output control module, a source connected to the carry signal output terminal, and a drain connected to a clock signal input terminal;
the second carry output TFT has a gate connected to the second output control module, a source connected to the first low level output terminal, and a drain connected to the carry signal output terminal;
the bootstrap capacitor is connected in parallel to the gate and the source of the first driving TFT;
the first driving TFT has a gate connected to the first output control module, a source connected to the driving signal output terminal, and a drain connected to the clock signal input terminal;
the second driving TFT has a gate connected to the second output control module, a source connected to the second low level output terminal, and a drain connected to the driving signal output terminal.

5. The shift register unit according to claim 4, wherein the second low level is greater than the first low level.

6. The shift register unit according to claims 4 or 5, wherein the second output control module includes a pull-down control TFT and a pull-down capacitor, wherein:
the pull-down control TFT has a gate connected to the pull-up node, a source connected to the first low level output terminal, a drain connected to the pull-down node and a first terminal of the pull-down capacitor; and
the pull-down capacitor has a second terminal connected to the clock signal input terminal.

7. The shift register unit according to claim 6,
wherein the first carry output TFT, the second carry output TFT, the first driving TFT and the second driving TFT are depletion TFTs.

8. A shift register comprising a plurality of the shift register units according to any of claims 1-7 at stages, wherein
except the shift register unit at the first stage, the input terminal of the shift register unit at each stage is connected to the carry signal output terminal of the shift register unit at the previous stage;
except the shift register unit at the last stage, the reset terminal of the shift register unit at each stage is connected to the carry signal output terminal of the shift register unit at the next stage;
the input terminal of the shift register unit at the first stage receives the start signal; and
the reset terminal of the shift register unit at the last stage receives the driving signal output from the shift register unit at the last stage.

9. A display apparatus comprising the shift register according to claim 8.
